(19) Europäisches Patentamt
European Patent Office
Office européen des brevets

(11) **EP 1 892 536 B1**

(12) **EUROPÄISCHE PATENTSCHRIFT**

(45) Veröffentlichungstag und Bekanntmachung des Hinweises auf die Patenterteilung:
**11.04.2012 Patentblatt 2012/15**

(51) Int Cl.:
***G01R 31/36*** *(2006.01)*

(21) Anmeldenummer: 06017466.1

(22) Anmeldetag: **22.08.2006**

(54) **Batterieüberwachungssystem**

Battery monitoring system

Système de surveillance d'une batterie

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**27.02.2008 Patentblatt 2008/09**

(73) Patentinhaber: **Delphi Technologies, Inc.**
**Troy, MI 48007 (US)**

(72) Erfinder:
• **Hirsch, Krystian**
**42489 Wülfrath (DE)**

• **Heise, Volker**
**54292 Trier (DE)**
• **Baur, Peter**
**54292 Trier (DE)**

(74) Vertreter: **Denton, Michael John**
**Delphi France SAS**
**Legal Staff**
**64, avenue de la Plaine de France**
**BP 65059 Tremblay en France**
**95972 Roissy CDG Cedex (FR)**

(56) Entgegenhaltungen:
EP-A- 1 632 782     US-A- 4 678 998
US-A- 6 002 238     US-A1- 2006 170 397

**Beschreibung**

Die Erfindung betrifft ein System zur Überwachung des Zustandes einer in einem Fahrzeug eingesetzten Batterie, an die wenigstens einen elektrischen Verbraucher und/oder wenigstens einen elektrischen Generator umfassende elektrische Elemente angeschlossen sind, mit Mitteln zum Erfassen der Batteriespannung, Mitteln zum Extrahieren von Spannungsfrequenzkomponenten aus der erfassten Batteriespannung bei verschiedenen Frequenzen, Mitteln zum Erfassen des aus bzw. in die Batterie fließenden Stromes, Mitteln zum Extrahieren von Stromfrequenzkomponenten aus dem erfassten Batteriestrom bei den gleichen Frequenzen, bei denen die Spannungsfrequenzkomponenten extrahiert werden, Mitteln zur Bestimmung interner Impedanzen der Batterie aus den bei einer jeweiligen Frequenz extrahierten Spannungsfrequenzkomponenten und Stromfrequenzkomponenten, Mitteln zum Speichern vorgegebener Beziehungen zwischen der internen Impedanz und dem Batteriezustand für jede der betreffenden Frequenzen sowie Mitteln zur Bestimmung des Batteriezustandes aus den ermittelten internen Impedanzen und den vorgegebenen Beziehungen. Bei den Fahrzeugen kann es sich insbesondere um Kraftfahrzeuge handeln.

Ein System dieser Art ist in der US-A-4 678 998 beschrieben.

In modernen Fahrzeugen ist die Batterie als Energiespeicher nicht nur für den Betrieb des Fahrzeugs wie beispielsweise das Starten, sondern zunehmend auch als Speicher für wiedergewonnene Energie wie beispielsweise zur Bremsenergiespeicherung von wesentlicher Bedeutung.

Um die dafür erforderliche Betriebssicherheit zu gewährleisten, muss die Möglichkeit bestehen, die internen Zustände der Batterie feststellen zu können. Diese können normalerweise durch Faktoren wie die folgenden bestimmt sein:

Aktueller Ladezustand (SoC), Alterungszustand (SoH) und für besondere Hauptfunktionen, Grad der Funktionserfüllung (SoF).

Bisher bekannte Systeme zur Bestimmung des Batteriezustandes umfassen Sensoren, die Strom-, Spannungs- und Temperatur-Messwerte als Eingangswerte für ein intern nachgebildetes Batteriemodell heranziehen. Ein Nachteil dieser Batteriemodelle besteht darin, dass sie relativ ungenau sind, was auf die Komplexität dieser Modelle insbesondere im Zusammenhang mit den allgemein gebräuchlichen Bleisäurebatterien und die begrenzten Mittel zur Berechnung zurückzuführen ist, die durch das eingebaute, die betreffenden Modelle umfassende System bereitgestellt werden. Der jeweils erforderliche Kompromiss zwischen der erforderlichen Komplexität und den Systemkosten erfolgt häufig auf Kosten der erzielbaren Leistung.

In der DE 042 55 321.4 ist als Verfahren zur Bestimmung der Batteriezustände bereits eine so genannte Impedanzspektroskopie beschrieben, die auf einer Analyse des Spektrums der internen Impedanz der zu prüfenden Batterie beruht. Diese erfordert für den Erhalt des Impedanzprofils einen bestimmten Test mittels einer Frequenzdurchlaufanregung, wodurch die Anwendung dieses Verfahrens bisher auf eine stationäre Testeinrichtung beschränkt war.

Bei dem aus der US 4 678 998 bekannten System werden die erforderlichen verschiedenen Frequenzkomponenten im Batteriestrom durch an die Batterie angeschlossene elektrische Verbraucher des betreffenden Fahrzeugs erzeugt. Von Nachteil ist hierbei, dass die betreffende, über die angeschlossenen, d.h. eingeschalteten, elektrischen Verbraucher erfolgende Anregung unkontrolliert ist und demzufolge nicht in jedem Fall die gewünschten Frequenzkomponenten erzeugt werden.

Bei einem aus der EP-A-1 632 782 bekannten Batterie-Überwachungssystem wird das gewünschte Frequenzspektrum durch entsprechendes Zu- und Abschalten der Lasten erzeugt.

In der US-A-2006/0170397 ist ein Batterie-Überwachungssystem beschrieben, bei dem die entsprechenden Frequenzen über eine zusätzliche Stromsenke erzeugt werden.

Aus der US-A-6 002 238 ist ein Batterie-Überwachungssystem bekannt, bei dem die gewünschten Frequenzen über eine zusätzlich zugeschaltete Stromerregungsschaltung erzeugt werden.

Der Erfindung liegt die Aufgabe zugrunde, ein verbessertes System der eingangs genannten Art zu schaffen, bei dem die zuvor genannten Nachteile beseitigt sind.

Diese Aufgabe wird erfindungsgemäß dadurch gelöst, dass Mittel zur Überwachung des Zustandes zumindest eines Teils der elektrischen Elemente sowie Mittel vorgesehen sind, um in Abhängigkeit vom erfassten Zustand der elektrischen Elemente den Zeitpunkt für eine jeweilige Spannungs- und Stromerfassung zu wählen und/oder die Bedingungen für eine jeweilige Spannungs- und Stromerfassung festzulegen, wobei die an die Batterie angeschlossenen, elektrischen Elemente daraufhin überwacht werden, ob sie in der Batteriespannung bzw. im Batteriestrom einen ein gewünschtes Frequenzspektrum erzeugenden Impuls bewirken, und dass die Batteriespannung und der Batteriestrom beim Auftreten eines entsprechenden Impulses erfasst werden.

Erfindungsgemäß wird also die so genannte Impedanzspektroskopie mit der Nachbildung oder Modellierung der Batterie kombiniert, um Batteriezustände, zu denen insbesondere der hohe Anforderungen stellende Alterungszustand (SoH) gehört, mit hoher Genauigkeit zu bestimmen. Das betreffende Überwachungssystem kann insbesondere in einem Fahrzeug integriert sein, wobei es dem Fahrzeugnutzer die betreffenden Informationen in-situ und in Echtzeit liefern kann. Die so genannte Impedanzspektroskopie kann also in einem im betreffenden Fahrzeug vorgesehenen Batterieüberwachungssystem integriert sein, wobei sie durch ein geeignete elektrische Elemente oder Lasten überwachendes oder kontrollierendes elektronisches System unterstützt wird.

Vorteilhafterweise können auch Mittel vorgesehen sein, um in Abhängigkeit vom erfassten Zustand der elektrischen Elemente einen Lastimpuls zu erzeugen, der in der Batteriespannung bzw. im Batteriestrom ein gewünschtes Frequenzspektrum mit sich bringt, wobei in diesem Fall die Batteriespannung und der Batteriestrom bei der Erzeugung eines entsprechenden Lastimpulses erfasst werden.

Gemäß einer bevorzugten Ausführungsform des erfindungsgemäßen Systems wird die Abtastrate bei der Erfassung der Batteriespannung und des Batteriestromes in Abhängigkeit von den Eigenschaften des auftretenden Impulses bzw. des erzeugten Lastimpulses gewählt.

In bestimmten Fällen ist es zudem von Vorteil, wenn in Abhängigkeit vom jeweiligen Batteriezustand eine Normalisierung der erfassten Batteriespannung bzw. des erfassten Batteriestroms erfolgt.

Vorteilhafterweise wird als Batteriezustand zumindest einer der folgenden Zustände überwacht: Alterungszustand (SoH), Ladezustand (SoC), Grad der Funktionserfüllung (SoF).

Bevorzugt wird als Batteriezustand zumindest der Alterungszustand SoH überwacht.

Gemäß einer zweckmäßigen praktischen Ausführungsform werden die Batteriespannung und der Batteriestrom beim Auftreten eines durch einen Anlasser/ Generator erzeugten Impulses erfasst. Dies ist insbesondere dann möglich, wenn der vom Anlasser/Generator erzeugte Impuls als verlässlich wiederholbarer Impuls auftritt, der den für die Spektralanalyse erforderlichen hohen Frequenzgehalt aufweist.

Dabei wird bevorzugt ausschließlich dieser vom Anlasser/ Generator erzeugte Impuls als Auslöseimpuls für die Erfassung der Batteriespannung und des Batteriestromes herangezogen.

In bestimmten Fällen kann es auch von Vorteil sein, wenn die Batteriespannung und der Batteriestrom beim Auftreten eines durch einen Anlasser/ Generator erzeugten Impulses, unterstützt durch eine zusätzliche, durch eine bestimmte künstliche, kontrollierbare Last erzeugte Anregung, erfasst werden. Bevorzugt ist diese künstliche, kontrollierbare Last Bestandteil des Batteriesensors.

Dabei können die Batteriespannung und der Batteriestrom beim Auftreten des durch den Anlasser/ Generator erzeugten Impulses, vorteilhafterweise unterstützt durch wenigstens einen zusätzlichen, über wenigstens ein bereits vorhandenes elektrisches Element, vorzugsweise elektrischen Verbraucher erzeugten künstlichen Impuls, erfasst werden.

Bevorzugt wird der künstliche Impuls über wenigstens eine elektrische Lampe und/oder wenigstens ein elektrisches Heizelement erzeugt. Zusätzlich oder alternativ können jedoch auch andere an die Batterie angeschlossene elektrische Elemente mit herangezogen werden. Dabei werden bevorzugt zumindest zwei Lasten in bestimmter zeitlicher Abfolge aktiviert.

Generell kann der dem erfindungsgemäßen Überwachungssystem zugrunde liegende Test also beispielsweise die folgenden Schritte umfassen:

    1. Bestimmen des geeigneten Zeitpunktes und/oder Kondition zum Testen
    2. Erkennen oder Generieren eines Testimpulses
    3. Messen der Strom- und Spannungswerte mit einer den Impulseigenschaften angemessenen Abtastrate
    4. Berechnen des Spektralimpedanzprofils auf der Basis der folgenden Beziehung: z(f): = u(f)/i(f), wobei z(f) die interne Impedanz der Batterie bei der Frequenz f, u(f) die Spannung bei der Frequenz f und i (f) der Strom bei der Frequenz f ist
    5. Durchführung einer Normalisierung aufgrund des Batteriezustandes (z.B. Laden/Entladen, Temperatur und/oder dergleichen)
    6. Feststellen der charakteristischen Eigenschaften
    7. Erstellen beispielsweise des Alterungszustands (SoH)-Indexes

Der die Bestimmung der charakteristischen Eigenschaften betreffende Schritt 6 hängt stark von den Eigenschaften der Batterie wie insbesondere der Nennkapazität, dem Alter und der Vorgeschichte ab. Die Wahl der geeigneten Verfahren, Charakteristika und Grenzwerte ist zweckmäßigerweise während des Kalibriervorgangs zu treffen. Allgemein können beispielsweise solche Verhaltensmethoden wie Fuzzy-Logik und/oder adaptive Filter zur Ableitung des endgültigen Wertes des Alterungszustandes (SoH) herangezogen werden.

Die Erfindung wird im Folgenden anhand von Ausführungsbeispielen unter Bezugnahme auf die Zeichnung näher erläutert; in dieser zeigen:

Fig. 1    eine schematische Teildarstellung einer beispielhaften Ausführungsform des Überwachungssystems, bei der ausschließlich der von einem Anlasser/Generator erzeugte Impuls als Auslöseimpuls oder Anregung für die Erfassung der Batteriespannung und des Batteriestromes herangezogen wird,

Fig. 2    eine schematische Teildarstellung einer beispielhaften Ausführungsform des Überwachungssystems, bei der die Batteriespannung und der Batteriestrom beim Auftreten des durch einen Anlasser/ Generator erzeugten Impulses, unterstützt durch eine zusätzliche, durch eine bestimmte künstliche, kontrollierbare Last erzeugte Anregung, erfasst werden,

Fig. 3    eine schematische Teildarstellung einer beispielhaften Ausführungsform des Überwachungssystems, bei der die Batteriespannung und der Batteriestrom beim Auftreten des durch einen Anlasser/ Generator erzeugten Impulses, unterstützt durch wenigstens einen zusätzlichen, über wenigstens ein bereits vorhandenes elektrisches Element erzeugten künstlichen Impuls, erfasst werden, wobei der geforderte Testpuls über zwei einfach elektrische Verbraucher erzeugt wird,

Fig. 4 eine vereinfachte schematische Darstellung einer Batterieüberwachung zur Erzeugung eines endgültigen Alterungszustandswertes (SoH), und

Fig. 5 ein Diagramm, das eine beispielhafte Ansteuerung zweier elektrischer Elemente oder Lasten zur Erzeugung von Testpulsen wiedergibt.

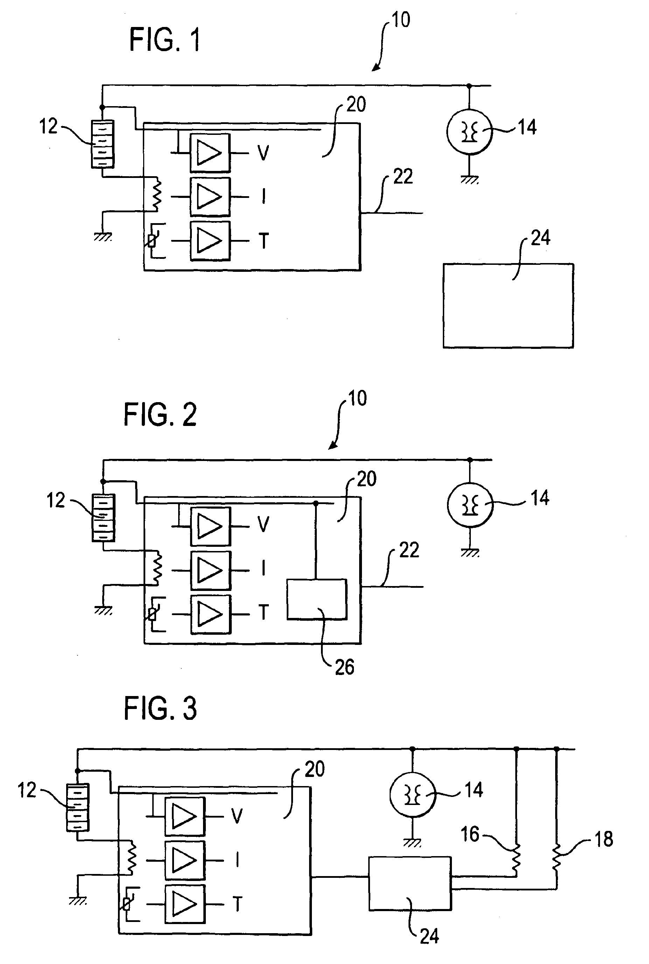

Fig. 1 zeigt in schematischer Teildarstellung eine beispielhafte Ausführungsform eines Systems 10 zur Überwachung des Zustandes einer in einem Fahrzeug, insbesondere Kraftfahrzeug eingesetzten Batterie 12, an die wenigstens einen elektrischen Verbraucher und/oder wenigstens einen elektrischen Generator umfassende elektrische Elemente angeschlossen sind, bei denen es sich beispielsweise um den Anlasser/ Generator 14 oder um andere elektrische Elemente 16, 18 (vgl. auch die Fig. 3) wie beispielsweise elektrische Lampen oder elektrische Heizelemente des Fahrzeugs handeln kann.

Das Überwachungssystem 10 umfasst im vorliegenden Fall einen Batteriesensor 20 zum Erfassen der Batteriespannung V, zum Erfassen des aus bzw. in die Batterie 12 fließenden Stromes I und zum Erfassen der Batterietemperatur T.

Der Sensor 20 ist beispielsweise über einen seriellen Bus 22 mit einer elektronischen Steuer- und/oder Auswerteeinheit 24 verbunden, die in das Bordsystem des Fahrzeugs integriert sein kann.

Beispielsweise mittels der elektronischen Steuer- und/oder Auswerteeinheit 24 werden aus der erfassten Batteriespannung V bei verschiedenen Frequenzen Spannungsfrequenzkomponenten extrahiert und aus dem erfassten Batteriestrom I bei den gleichen Frequenzen, bei denen die Spannungsfrequenzkomponenten extrahiert werden, Stromfrequenzkomponenten extrahiert. Beispielsweise mittels der elektronischen Steuer- und/ oder Auswerteeinheit 24 werden zudem aus den bei einer jeweiligen Frequenz extrahierten Spannungsfrequenzkomponenten und Stromfrequenzkomponenten interne Impedanzen der Batterie 12 bestimmt oder berechnet.

Beispielsweise mittels der elektronischen Steuer- und/oder Auswerteeinheit 24 werden zudem vorgegebene Beziehungen zwischen der internen Impedanz und dem Batteriezustand für jede der betreffenden Frequenzen gespeichert.

Schließlich ist diese elektronische Steuer- und/ oder Auswerteeinheit 24 so ausgelegt, dass sie den Batteriezustand aus den ermittelten internen Impedanzen und den vorgegebenen Beziehungen bestimmt.

Bei der vorliegenden, in der Fig. 1 wiedergegebenen beispielhaften Ausführungsform wird ausschließlich der von dem Anlasser/ Generator 14 des Fahrzeugs erzeugte Impuls als Auslöseimpuls oder Anregung für die Erfassung der Batteriespannung V und des Batteriestroms I herangezogen.

In solchen Fällen, in denen der vom Anlasser/ Generator 14 erzeugte Impuls als verlässlich wiederholbarer Impuls auftritt, der den erforderlichen hohen Frequenzgehalt für die Impedanzspektralanalyse liefert, kann dieser vom Anlasser/ Generator 14 erzeugte Impuls herangezogen werden, was eine äußerst effiziente und einfache Ausführung mit sich bringt. Die Grenzen dieser Ausführung sind allerdings durch die Tatsache gegeben, dass in der zwischen den Anlasserimpulsen liegenden Zeitspanne, die sehr lang sein kann, nicht genügend Eingangsdaten zur Verfügung stehen, um zuverlässige und für den jeweiligen aktuellen Zeitpunkt gültige Informationen z.B. über den Alterungszustand (SoH) zu erhalten.

Fig. 2 zeigt in schematischer Teildarstellung eine beispielhafte Ausführungsform des Überwachungssystems 10, bei der die Batteriespannung V und der Batteriestrom I beim Auftreten des durch den Anlasser/Generator 14 erzeugten Impulses, unterstützt durch eine zusätzliche, durch eine bestimmte künstliche, kontrollierbare Last 26 erzeugte Anregung, erfasst werden. Diese künstliche, kontrollierbare Last 26 ist bevorzugt integraler Bestandteil des Batteriesensors 20. Bevorzugt handelt es sich hierbei um eine vom Sensor 20 kontrollierte interne (on-board) künstliche Last, die die Erzeugung beispielsweise der weiter unten näher erläuterten Testpulse ermöglicht.

Diese Ausführung überwindet die zuvor genannten Grenzen der Ausführung gemäß Fig. 1 durch die Heranziehung einer zusätzlichen Anregung, die durch einen oder mehrere bestimmte künstliche, kontrollierbare Lasten 26 erzeugt wird, die vom Sensor 20 bzw. der mit diesem verbundenen elektronischen Steuer- und/ oder Auswerteeinheit 24 überwacht werden, wobei die wenigstens eine zusätzliche künstliche, kontrollierbare Last 26 vorzugsweise im Sensor 20 integriert ist.

Der Sensor 20 bzw. die mit diesem verbundene elektronische Steuer- und/oder Auswerteeinheit 24 kann in Abhängigkeit von seinen Echtzeitanforderungen einen geeigneten Impuls über das erforderliche Spektrum oder gezielt für Frequenzen erzeugen, die für den gegebenen Typ der überprüften Batterie 12 besonders signifikant sind.

Der Sensor 20 bzw. die mit diesem verbundene elektronische Steuer- und/oder Auswerteeinheit 24 kann die Informationen über den Zustand der anderen Lasten in den Fahrzeugsystemen dazu heranziehen, den geeigneten Zeitpunkt und die geeigneten Bedingungen für den Test auszuwählen, um beispielsweise Interferenzen mit existierenden Anregungen zumindest zu begrenzen oder mögliche Seiteneffekte (Sichtbarkeit) für den Benutzer zu unterdrücken.

Im Übrigen kann das Überwachungssystem 10 zumindest im Wesentlichen den gleichen Aufbau wie bei der Ausführung gemäß Fig. 1 besitzen. Einander entsprechenden Teilen sind gleiche Bezugszeichen zugeordnet. Der Einfachheit halber ist im vorliegenden Fall jedoch die auch hier vorgesehene elektronische Steuer- und/oder Auswerteeinheit nicht dargestellt.

Fig. 3 zeigt in schematischer Teildarstellung eine Ausführungsform des Überwachungssystems 10, bei der die Batteriespannung V und der Batteriestrom I beim Auftreten des durch den Anlasser/Generator 14 erzeugten Impulses, unterstützt durch wenigstens einen zusätzlichen, über wenigstens ein bereits vorhandenes elektrisches Element 16, 18 erzeugten künstlichen Impuls, erfasst werden. Bei den bereits existierenden elektrischen Elementen 16, 18 kann es sich beispielsweise um elektrische Lampen oder elektrische Heizelemente handeln. Indem solche bereits vorhandenen elektrischen Elemente 16, 18 zur Anregung des Testes mit herangezogen werden, können zusätzliche künstliche, kontrollierbare Lasten entfallen, wodurch Kosten eingespart und der Aufwand minimiert wird.

Es werden hier also zwei einfache elektrische Verbraucher benötigt, um den geforderten Testpuls zu generieren. Denkbar ist beispielsweise der Einsatz einer zweistufigen Last (z.B. "Low-Beam"- und "High-Beam"-Lampe oder zweistufige Heizung).

Dabei ist bevorzugt eine Unterstützung des betreffenden Tests durch das restliche elektrische und/oder elektronische Fahrzeugsystem insbesondere für den Austausch an Informationen und Befehlen zwischen dem Sensor 20 und anderen intelligenten Elementen wie beispielsweise dem Bordcomputer vorgesehen. In der Darstellung gemäß Fig. 3 ist beispielsweise eine fahrzeuginterne, einen Controller umfassende Steuer- und/oder Auswerteeinheit 24 zu erkennen. Auch die im übrigen noch genannten elektrischen oder elektronischen Einrichtungen können insbesondere Teil dieser Einheit sein. Diese Steuer- und/oder Auswerteeinheit 24 kann neben den betreffenden elektronischen Komponenten erforderlichenfalls auch die jeweiligen elektrischen Komponenten mit umfassen.

Da moderne Fahrzeugsysteme mit den hoch vernetzten Netzwerken bereits die Möglichkeit besitzen, die erforderliche Menge an Befehlen und Informationen auszutauschen, kann die hier angewandte Impedanzspektroskopie und Überwachung des Batteriezustandes vorteilhafterweise in das Fahrzeugsystem integriert werden. Hierzu bedarf es allerdings einer entsprechenden Konfiguration des Gesamtsystems. Dazu müsste das Batteriezustands-Überwachungssystem auf der Ebene der Fahrzeugdefinition verwirklicht werden, wozu normalerweise eine volle Unterstützung durch und eine Zusammenarbeit mit dem Erstausrüster erforderlich ist.

Im übrigen kann auch die vorliegende Ausführungsform zumindest im Wesentlichen wieder so ausgeführt sein wie die der Fig. 1, wobei einander entsprechenden Teilen wieder gleiche Bezugszeichen zugeordnet sind. Auch im vorliegenden Fall ist die Steuer- und/oder Auswerteeinheit 24 der Einfachheit halber nicht dargestellt.

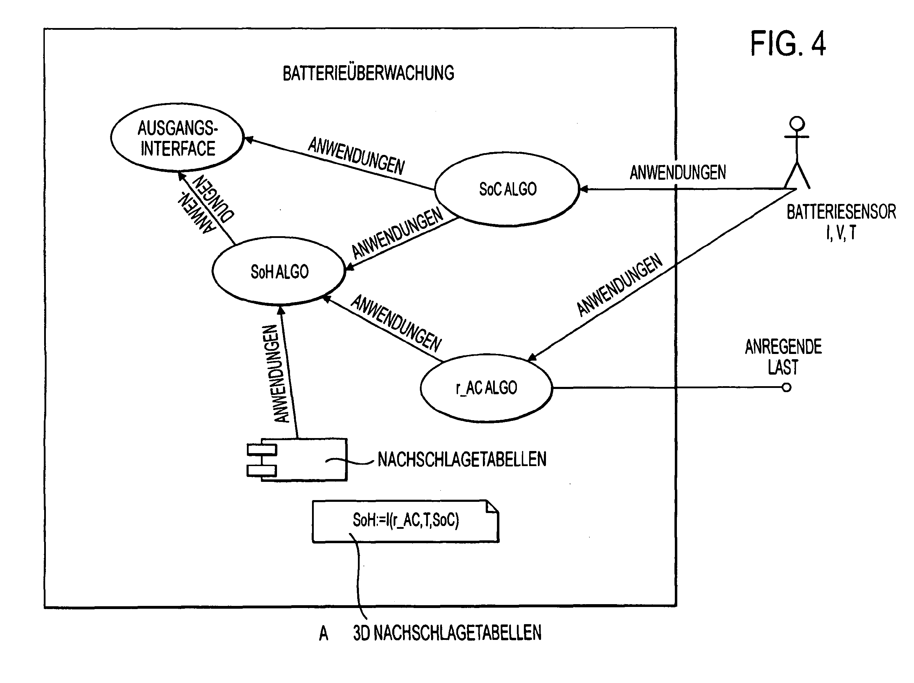

Fig. 4 zeigt in vereinfachter schematischer Darstellung eine beispielhafte Ausführungsform eines Batterieüberwachungssystems zur Erzeugung eines endgültigen Alterungszustandswertes (SoH).

Wie der Fig. 4 entnommen werden kann, kann der endgültige Alterungszustandswert (SoH) durch eine bestimmte Rechenfunktion erzeugt werden, wobei der aktuelle Ladezustand (SoC), die Batterietemperatur T und das Impedanzprofil z(f) als Eingangsdaten dienen. Die Erzeugung des Alterungszustandswertes (SoH) kann mittels einer kundenspezifischen Nachschlagetabelle und/oder in Kombination mit solchen Verhaltensverfahren, wie sie weiter oben erwähnt wurden, erfolgen. Die Definition der Nachschlagetabelle ist Teil des auf einem bestimmten Algorithmus beruhenden Kalibriervorgangs.

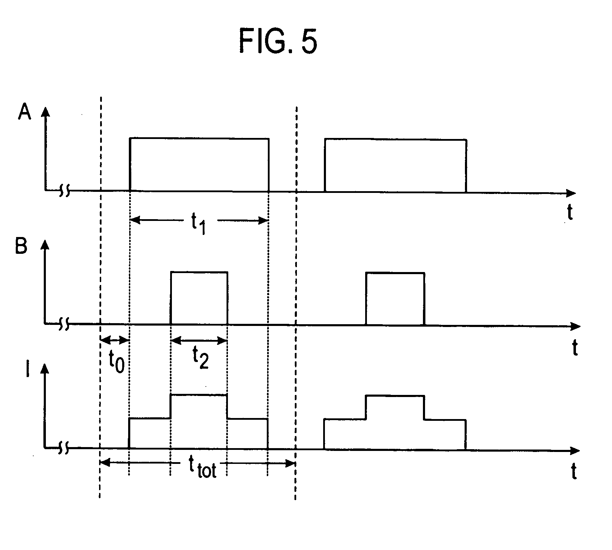

Das Diagramm gemäß Fig. 5 zeigt eine beispielhafte Ansteuerung zweier elektrischer Elemente oder Lasten A, B zur Erzeugung von Testpulsen. Dabei ist die zeitliche Anordnung der Aktivierung der Lasten A und B so gewählt, dass der resultierende Strom I dem dargestellten Verlauf über der Zeit t folgt.

Wie sich aus dem Diagramm ergibt, ist am Anfang eines vorgebbaren Zeitintervals $t_{tot}$ zunächst weder die Last A noch die Last B aktiviert. Nach der Zeit $t_0$ wird dann zunächst die Last A aktiviert. Diese Last A bleibt während der Zeit $t_1$ aktiviert. Innerhalb dieses Zeitintervals $t_1$ wird dann auch die Last B aktiviert. Diese Last B bleibt während der Zeit $t_2$ aktiviert, die kleiner ist als $t_1$.

Dabei kann die Ansteuerung der Lasten A und B beispielsweise durch die folgenden Beziehungen bestimmt sein:

$$t_2 = 0,36 \times t_{tot}$$

$$t_1 = 0,64 \times t_{tot}$$

$$t_0 = 0,18 \times t_{tot}.$$

Wie anhand des Diagramms zu erkennen ist, kann die Zeitspanne $t_2$ der Aktivierung der Last B beispielsweise zentriert innerhalb der Zeitspanne $t_1$ der Aktivierung der Last A liegen. Entsprechend ergibt sich ein symmetrischer Verlauf des Stromes I mit einem höheren Wert im mittleren Bereich.

Die beim vorliegenden Ausführungsbeispiel vorgesehene Anordnung stellt eine Optimierung der Annäherung der Ansteuerung an eine sinusförmige Ansteuerung dar. Die durch die Zeiten $t_0$, $t_1$ und $t_2$ definierte Form bringt die wenigsten harmonischen Komponenten mit sich, so dass unerwünschte Störungen (EMV) auf ein Minimum reduziert werden und relativ einfache rechteckförmige Verläufe beibehalten werden.

Bei den Lasten kann es sich beispielsweise um künstliche oder normale Lasten handeln, wobei grundsätzlich elektrische Verbraucher und/oder Generatoren denkbar sind.

Bezugszeichenliste

| | |
|---|---|
| 10 | Überwachungssystem |
| 12 | Batterie |
| 14 | Anlasser/ Generator, elektrisches Element |
| 16 | elektrisches Element, Verbraucher |
| 18 | elektrisches Element, Verbraucher |
| 20 | Batteriesensor |
| 22 | serieller Bus |
| 24 | Steuer- und/oder Auswerteeinheit |
| 26 | zusätzliche künstliche, kontrollierbare Last |

| | |
|---|---|
| I | Batteriestrom |
| V | Batteriespannung |
| T | Batterietemperatur |

**Patentansprüche**

1. System (10) zur Überwachung des Zustandes einer in einem Fahrzeug eingesetzten Batterie (12), an die wenigstens einen elektrischen Verbraucher und/oder wenigstens einen elektrischen Generator umfassende elektrische Elemente (14 - 18) angeschlossen sind, mit Mitteln (20) zum Erfassen der Batteriespannung (V), Mitteln (24) zum Extrahieren von Spannungsfrequenzkomponenten aus der erfassten Batteriespannung (V) bei verschiedenen Frequenzen, Mitteln (20) zum Erfassen des aus bzw. in die Batterie (12) fließenden Stromes (I), Mitteln zum Extrahieren von Stromfrequenzkomponenten aus dem erfassten Batteriestrom (I) bei den gleichen Fre-quenzen, bei denen die Spannungsfrequenzkompo-nenten extrahiert werden, Mitteln (24) zur Bestimmung interner Impedanzen der Batterie (12) aus den bei einer jeweiligen Frequenz extrahierten Span-nungsfrequenzkomponenten und Stromfrequenz-komponenten, Mitteln (24) zum Speichern vorgegebener Beziehungen zwischen der internen Impedanz und dem Batteriezustand für jede der betreffenden Frequenzen sowie Mitteln (24) zur Bestimmung des Batteriezustandes aus den ermittelten internen Impedanzen und den vorgegebenen Beziehungen, **dadurch gekennzeichnet, dass** Mittel (24) zur Überwachung des Zustandes zumindest eines Teils der elektrischen Elemente (14 - 18) sowie Mittel (24) vorgesehen sind, um in Abhängigkeit vom erfassten Zustand der elektrischen Elemente (14 - 18) den Zeitpunkt für eine jeweilige Spannungs- und Stromerfassung zu wählen und/ oder die Bedingungen für eine jeweilige Spannungs- und Stromerfassung festzulegen, wobei die an die Batterie (12) angeschlossenen elektrischen Elemente (14 - 18) daraufhin überwacht werden, ob sie in der Batteriespannung (V) bzw. im Batteriestrom (I) einen ein gewünschtes Frequenzspektrum erzeugenden Impuls bewirken, und dass die Batteriespannung (V) und der Batteriestrom (I) bei Auftreten eines entsprechenden Impulses erfasst werden.

2. System nach Anspruch 1,
   **dadurch gekennzeichnet, dass** Mittel (24) vorgesehen sind, um in Abhängigkeit vom erfassten Zustand der elektrischen Elemente (14 - 17) einen Lastimpuls zu erzeugen, der in der Batteriespannung (V) bzw. im Batteriestrom (I) ein gewünschtes Frequenzspektrum mit sich bringt, und dass die Batteriespannung (V) und der Batteriestrom (I) bei der Erzeugung eines entsprechenden Lastimpulses erfasst werden.

3. System nach Anspruch 1 oder 2,
   **dadurch gekennzeichnet, dass** die Abtastrate bei der Erfassung der Batteriespannung (V) und des Batteriestromes (I) in Abhängigkeit von den Eigenschaften des auftretenden Impulses bzw. des erzeugten Lastimpulses gewählt wird.

4. System nach einem der vorhergehenden Ansprüche,
   **dadurch gekennzeichnet, dass** in Abhängigkeit vom jeweiligen Batteriezustand eine Normalisierung der erfassten Batteriespannung (V) bzw. des erfassten Batteriestromes (I) erfolgt.

5. System nach einem der vorhergehenden Ansprüche,
   **dadurch gekennzeichnet, dass** als Batteriezustand zumindest einer der folgenden Zustände überwacht wird: Alterungszustand (SoH), Ladezustand (SoC), Grad der Funktionserfüllung (SoF).

6. System nach einem der vorhergehenden Ansprüche,
   **dadurch gekennzeichnet, dass** als Batteriezustand zumindest der Alterungszustand (SoH) überwacht wird.

7. System nach einem der vorhergehenden Ansprüche,

**dadurch gekennzeichnet,**
**dass** die Batteriespannung (V) und der Batteriestrom (I) beim Auftreten eines durch einen Anlasser/Generator (14) erzeugten Impulses erfasst werden.

8. System nach Anspruch 7,
**dadurch gekennzeichnet,**
**dass** ausschließlich der von dem Anlasser/Generator (14) erzeugte Impuls als Auslöseimpuls für die Erfassung der Batteriespannung (V) und des Batteriestromes (I) herangezogen wird.

9. System nach Anspruch 7,
**dadurch gekennzeichnet,**
**dass** die Batteriespannung (V) und der Batteriestrom (I) beim Auftreten eines durch einen Anlasser/Generator (14) erzeugten Impulses, unterstützt durch eine zusätzliche, durch eine bestimmte künstliche, kontrollierbare Last (26) erzeugte Anregung, erfasst werden.

10. System nach Anspruch 7,
**dadurch gekennzeichnet,**
**dass** die Batteriespannung (V) und der Batteriestrom (I) beim Auftreten eines durch einen Anlasser/Generator (14) erzeugten Impulses, unterstützt durch wenigstens einen zusätzlichen, über wenigsten ein bereits vorhandenes elektrisches Element, vorzugsweise elektrischen Verbraucher (16, 18) erzeugten künstlichen Impuls, erfasst werden.

11. System nach Anspruch 10,
**dadurch gekennzeichnet,**
**dass** der künstliche Impuls über wenigstens eine elektrische Lampe und/oder wenigstens ein elektrisches Heizelement erzeugt wird.

**Claims**

1. System (10) for monitoring the state of a battery (12) used in a vehicle and to which electrical elements (14-18) comprising at least one electrical consumer and/or at least one electrical generator are connected, having means (20) for the detection of the battery voltage (V), means (24) for the extraction of voltage frequency components from the detected battery voltage (V) at different frequencies, means (20) for the detection of the current (I) flowing out of or into the battery (12), means for the extraction of current frequency components from the detected battery current (I) at the same frequencies at which the voltage frequency components are extracted, means (24) for the determination of internal impedances of the battery (12) from the voltage frequency components and current frequency components extracted at a respective frequency, means (24) for the storage of predetermined relationships between the internal impedance and the battery state for each of the respective frequencies and means (24) for the determination of the battery state from the determined internal impedances and the predetermined relationships,
**characterized in that**
means (24) are provided for monitoring the state of at least some of the electrical elements (14-18) as well as means (24) in order to select the time for a respective voltage and current detection in dependence on the detected state of the electrical elements (14-18) and/or to fix the conditions for a respective voltage and current detection, wherein the electrical elements (14-18) connected to the battery (12) are monitored as to whether they effect a pulse generating a desired frequency spectrum in the battery voltage (V) or in the battery current (I), and **in that** the battery voltage (V) and the battery current (I) are detected on the occurrence of a corresponding pulse.

2. System in accordance with claim 1,
**characterized in that**
means (24) are provided in order to generate a load pulse in dependence on the detected state of the electrical elements (14-17) which brings about a desired frequency spectrum in the battery voltage (V) or in the battery current (I), and **in that** the battery voltage (V) and the battery current (I) are detected on the generation of a corresponding load pulse.

3. System in accordance with claim 1 or claim 2,
**characterized in that**
the sampling rate on the detection of the battery voltage (V) and of the battery current (I) is selected in dependence on the properties of the occurring pulse or of the generated load pulse.

4. System in accordance with any one of the preceding claims,
**characterized in that**
a normalization of the detected battery voltage (V) or of the detected battery current (I) takes place in dependence on the respective battery state.

5. System in accordance with any one of the preceding claims,
**characterized in that**
at least one of the following states is monitored as the battery state: aging state (SoH), charge state (SoC), degree of function satisfaction (SoF).

6. System in accordance with any one of the preceding claims,
**characterized in that**
at least the age state (SoH) is monitored as the battery state.

**7.** System in accordance with any one of the preceding claims,
**characterized in that**
the battery voltage (V) and the battery current (I) are detected on the occurrence of a pulse generated by a starter/generator (14).

**8.** System in accordance with claim 7,
**characterized in that**
only the pulse generated by the starter/generator (14) is used as the trigger pulse for the detection of the battery voltage (V) and of the battery current (I).

**9.** System in accordance with claim 7,
**characterized in that**
the battery voltage (V) and the battery current (I) are detected on the occurrence of a pulse generated by a starter/generator (14), assisted by an additional excitation generated by a specific artificial controllable load (26).

**10.** System in accordance with claim 7,
**characterized in that**
the battery voltage (V) and the battery current (I) are detected on the occurrence of a pulse generated by a starter/generator (14), assisted by at least one additional artificial pulse generated via at least one electrical element, preferably an electrical consumer (16, 18), already present.

**11.** System in accordance with claim 10,
**characterized in that**
the artificial pulse is generated via at least one electrical lamp and/or at least one electrical heating element.

**Revendications**

**1.** Système (10) pour la surveillance de l'état d'une batterie (12) employée dans un véhicule, à laquelle sont raccordés des éléments électriques (14-18) comprenant au moins un dispositif utilisateur électrique et/ou au moins un générateur électrique, comprenant des moyens (20) pour détecter la tension de batterie (V), des moyens (24) pour extraire des composantes de fréquence de tension hors de la tension de batterie (V) détectée pour différentes fréquences, des moyens (20) pour détecter le courant (I) qui s'écoule en sortant ou en rentrant dans la batterie (12), des moyens pour extraire des composantes de fréquence de courant hors du courant de batterie (I) détecté pour les mêmes fréquences pour lesquelles les composantes de fréquence de tension sont extraites, des moyens (24) pour déterminer des impédances internes de la batterie (12) à partir des composantes de fréquence de tension et des composantes de fréquence de courant extraites à une fréquence respective, des moyens (24) pour mémoriser des relations prédéterminées entre l'impédance internes et l'état de la batterie pour chacune des fréquences concernées, ainsi que des moyens (24) pour déterminer l'état de la batterie à partir des impédances internes déterminées et des relations prédéterminées,
**caractérisé en ce que**
il est prévu des moyens (24) pour surveiller l'état d'au moins une partie des éléments électriques (14-18) ainsi que des moyens (24) pour choisir, en fonction de l'état détecté des éléments électriques (14-18), l'instant pour une détection de tension et de courant respective et/ou fixer les conditions pour une détection de tension et de courant respective, et les éléments électriques (14-18) raccordés à la batterie (12) sont surveillés quant à savoir s'ils produisent dans la tension de batterie (V) ou dans le courant de batterie (I) une impulsion générant un spectre de fréquences souhaité, et **en ce que** la tension de batterie (V) et le courant de batterie (I) sont détectés lors de l'apparition d'une impulsion correspondante.

**2.** Système selon la revendication 1,
**caractérisé en ce qu'**il est prévu des moyens pour générer une impulsion de charge en fonction de l'état détecté des éléments électriques (14-17), impulsion qui entraîne dans la tension de batterie (V) ou dans le courant de batterie (I) un spectre de fréquences souhaité, et **en ce que** la tension de batterie (V) et le courant de batterie (I) sont détectés lors de la génération d'une impulsion de charge correspondante.

**3.** Système selon la revendication 1 ou 2,
**caractérisé en ce que** la cadence lors de la détection de la tension de batterie (V) et du courant de batterie (I) est choisie en fonction des propriétés de l'impulsion qui apparaît ou de l'impulsion de charge générée.

**4.** Système selon l'une des revendications précédentes,
**caractérisé en ce que**, en fonction de l'état respectif de la batterie, il se produit une normalisation de la tension de batterie (V) détectée ou du courant de batterie (I) détecté.

**5.** Système selon l'une des revendications précédentes,
**caractérisé en ce que** l'on surveille à titre d'état de batterie au moins l'un des états suivants : état de vieillissement (SoH), état de chargement (SoC), degré d'efficacité fonctionnelle (SoF).

**6.** Système selon l'une des revendications précédentes,
**caractérisé en ce que** l'on surveille à titre d'état de batterie au moins l'état de vieillissement (SoH).

7. Système selon l'une des revendications précédentes,
**caractérisé en ce que** la tension de batterie (V) et le courant de batterie (I) sont détectés lors de l'apparition d'une impulsion générée par un démarreur/générateur (14).

8. Système selon la revendication 7,
**caractérisé en ce que** l'impulsion générée par le démarreur/générateur (14) est exclusivement exploitée comme impulsion de déclenchement pour la détection de la tension de batterie (V) et du courant de batterie (I).

9. Système selon la revendication 7,
**caractérisé en ce que** la tension de batterie (V) et le courant de batterie (I) sont détectés lors de l'apparition d'une impulsion générée par un démarreur/générateur (14), avec assistance d'une excitation supplémentaire générée par une charge (26) artificielle déterminée susceptible d'être contrôlée.

10. Système selon la revendication 7,
**caractérisé en ce que** la tension de batterie (V) et le courant de batterie (I) sont détectés lors de l'apparition d'une impulsion générée par un démarreur/générateur (14), avec assistance d'au moins une impulsion artificielle supplémentaire, générée via au moins un élément électrique déjà existant, de préférence un dispositif utilisateur électrique (16, 18).

11. Système selon la revendication 10,
**caractérisé en ce que** l'impulsion artificielle est générée via au moins une lampe électrique et/ou au moins un élément chauffant électrique.

FIG. 1

FIG. 2

FIG. 3

FIG. 4

BATTERIEÜBERWACHUNG

A    3D NACHSCHLAGETABELLEN

EP 1 892 536 B1

# FIG. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4678998 A
- DE 04255321
- EP 1632782 A
- US 20060170397 A
- US 6002238 A